# EUROPÄISCHE PATENTSCHRIFT

(11) **EP 1 142 118 B1**
(45) Veröffentlichungstag und Bekanntmachung des Hinweises auf die Patenterteilung: **09.04.2003**
(21) Anmeldenummer: 99966953.4
(22) Anmeldetag: 11.12.1999
(51) Int. Cl.: H03K 17/975

(54) **TASTSENSOR**
TACTILE SENSOR
PALPEUR

(30) Priorität: 23.12.1998 DE 19859779
(43) Veröffentlichungstag der Anmeldung: 10.10.2001
(73) Patentinhaber: rubitec Gesellschaft für Innovation und Technologie der Ruhr-Universität Bochum mbH, 44801 Bochum (DE)
(72) Erfinder: SCHMIDT, Peer, D-44801 Bochum (DE); MAEL, Eric, D-13187 Berlin (DE); WÜRTZ, Rolf, D-44803 Bochum (DE)
(74) Vertreter: Schneiders, Josef, Dipl.-Ing.
(86) Internationale Anmeldenummer: EP9909834
(87) Internationale Veröffentlichungsnummer: WO00039927

(56) Entgegenhaltungen:
- EP-A- 0 535 907
- DE-A- 19 510 599
- DE-C- 4 240 531
- US-A- 4 404 481

## Beschreibung

Die Erfindung betrifft eine Vorrichtung zur Registrierung von Berührungen mit wenigstens einem kraftempfindlichen Meßwandler, wobei die Kraftankopplung an den Meßwandler über eine Faser oder ein Faserbündel erfolgt.

Tastsensoren werden überall dort eingesetzt, wo Interaktionen einer Kontaktfläche mit der Umgebung registriert werden sollen. Sie dienen im einfachsten Fall dazu, Kontakt zu erkennen. Bei der Manipulation von Gegenständen in der Robotik sollen sie den Tastsinn des Menschen ersetzen und ausreichende Information über die Interaktion von Kontaktfläche (Greifer oder Finger) und Tastobjekt liefern, um Bewegungen und Griffe planen zu können.

Es sind verschiedene Sensoren bekannt, mit denen Tasteindrücke technisch registriert werden können (Tastsensoren). Dabei führt die Interaktion mit einem Objekt zur Änderung einer für den Tastsinn charakteristischen Größe. Die Änderung dieser Größe kann mit einem geeigneten Verfahren ausgewertet werden.

Abhängig vom Konstruktionsprinzip der Sensoren und vom Verfahren zur Auswertung der Sensordaten ist es möglich, statische und/oder dynamische Tastinformationen zu erhalten.

Vorbekannte Sensoren zur Aufnahme von Tastsensoren werden im Folgenden beschrieben:

Es ist bekannt, Normal- und Scherkräfte über eine kapazitive Zelle zu messen, wobei Normalkräfte durch Änderungen des Elektrodenabstandes und Scherkräfte durch Verschiebung der Elektroden zueinander registriert werden. (Fan, L.S., White, R.M., and Muller, R.S. 1984. A mutual capacitive normal- and shear-sensitive tactile sensor. IEEE Int. Electron. Devices Mg. 220-222).

Normalkräfte lassen sich auch mittels piezo-resistiver Sensoren messen: Die Firma Interlink-Electronics stellt eine mit einem halbleitenden Polymer bedruckte Folie her, deren Widerstand sich bei einwirkendem Druck verringert. Dieser Widerstand kann mit unter der Folie liegenden Elektroden gemessen werden. (Interlink Electronics Europe. 1990. G.D. de Luxemburg. Druck- und Positionssensoren eine aufstrebende Technologie).

Vibrationen können mit piezo-elektrischen Sensoren registriert werden, indem ein piezo-elektrisches Material die auftretenden Schwingungen in eine elektrische Spannung umsetzt, welche mit geeigneten Verfahren ausgewertet werden kann (Jockusch. 1996. Taktile Sensorik für eine Roboterhand. Technische Universität Bielefeld).

Dynamische Informationen über Annäherungsgeschwindigkeit zwischen Sensor und Objekt lassen sich mit induktiven Sensoren registrieren. So besteht die Möglichkeit, zwei Spulen in ein elastisches Material einzuarbeiten und die Änderungen der magnetischen Kopplung bei sich verändernder Geometrie auszuwerten. Auf diese Weise sind außerdem auch statische Messungen möglich (Peura, R. A. 1978. Basic transducers and principles. In: J. G. Webster (ed.), Medical instrumentation: application and design. Boston: Housten Mifflin).

Eine Vorrichtung der eingangs genannten Art wird beispielsweise in der DE 42 40 531 C1 beschrieben. Es handelt sich hierbei um eine Eingabevorrichtung für einen Computer, welche als ein mit Sensoren bestückter Handschuh ausgebildet ist Die vorbekannte Vorrichtung dient dazu, Positions- und Bewegungsdaten einer Hand zu registrieren und diese Daten an einen Computer zu übertragen. Die vorbekannte Eingabevorrichtung weist außerdem Berührungssensoren auf, welche zur Messung der Druckverteilung an der Hand dienen. Als Sensor für die Bestimmung des Beugungswinkels der Fingergelenke schlägt die vorbekannte Vorrichtung als Meßwandler eine Spule vor, die einen in der Spule beweglich gelagerten Tauchkern umgibt. An dem Tauchkern ist eine flexible Faser befestigt, welche Zug- und Schubkräfte auf den Tauchkern überträgt, so daß durch die Bewegung des Tauchkerns bei einer Beugung der Fingergelenke die Induktivität der Spule verändert wird. Als Tastfühler werden bei dem vorbekannten Datenhandschuh als flache Kondensatoren ausgebildete Drucksensoren verwendetet, deren Platten durch Krafteinwirkung federnd gegeneinander beweglich sind. Durch unterschiedliche auf die Kondensatorflächen einwirkende Kräfte ergeben sich dadurch verschiedene Kapazitätswerte, was zur Ermittlung des einwirkenden Drucks ausgenutzt wird.

Die rezeptiven Elemente aller vorbekannter Sensoren befinden sich entweder in der Kontaktfläche und kommen direkt mit dem Tastobjekt in Berührung, oder die Kontaktfläche selbst besteht aus einer flexiblen Schicht und die rezeptiven Elemente der Sensoren befinden sich direkt unterhalb dieser Schicht. Für statische Sensoren, deren Aufgabe es ist, Kräfte zu messen, ist diese Ankopplung zwischen rezeptivem Element und Tastobjekt ausreichend.

Dynamische Sensoren, welche Berührung, Geschwindigkeit und/oder Vibration registrieren sollen, sind durch diese Ankopplung jedoch Einschränkungen untermrorfen.

Die mechanischen Eigenschaften einer Kontaktfläche sind durch die verwendeten Materialien bestimmt. Abhängig von der Art der Anwendung können dabei verschiedene Ziele verfolgt werden. So kann es zum Beispiel bei Kontakt mit Objekten erwünscht sein, möglichst schnell ein hohen Druck aufzubauen oder auch eine möglichst große Eindrucktiefe zu erzielen und den Druck dabei nur langsam aufzubauen, um z. B. eine möglichst gute Anpassung an das Tastobjekt zu ermöglichen. Dynamische Sensoren sollen dabei Messungen vornehmen, jedoch nicht die mechanischen Eigenschaften der Kontaktfläche bestimmen. Dies ist bei der Anordnung herkömmlicher Sensoren unterhalb einer flexiblen Kontaktfläche zwar gewährleistet, jedoch werden dabei die Empfindlichkeit und Genauigkeit dynamischer Sensoren stark reduziert und sind darüber hinaus abhängig von den Eigenschaften der Kontaktfläche. Bei einer Anordnung die einen direkten Kontakt der rezeptiven Elemente mit dem Tastobjekt erlaubt, ist es zwar möglich, Sensoren innerhalb einer flexiblen Schicht einzubetten, diese kann jedoch um die notwendige Stabilität zu bieten, nicht beliebig flexibel gestaltef werden. Die Eigenschaften der Kontaktfläche werden dabei maßgeblich von den eingebetteten Sensoren bestimmt, und die Wegstrecke von der Berührung bis zum Aufbau eines hohen Druckes ist dabei im allgemeinen nur sehr kurz. Messungen sind in jedem Fall nur möglich wenn das Objekt die Kontaktfläche bereits berührt hat. Sofern am Ort des Sensors aufgrund der geometrischen Gegebenheiten kein direkter Kontakt zur Oberfläche und Kontaktfläche stattfindet, existiert keine Kopplung von Sensor und rezeptivem Element und Messungen sind nicht möglich.

Die Größe und die Art der Ankopplung der rezeptiven Elemente der vorbekannten Sensoren erlaubt es außerdem nicht, durch Abtasten Informationen über die Oberflächenstruktur eines Objektes zu erhalten, sofern diese nicht ausgesprochen grob ist.

Der vorliegenden Erfindung liegt die folgende Aufgabenstellung zugrunde:

Es sollen Berührungen dynamisch registriert werden, wobei die auf das Tastobjekt ausgeübten Kräfte möglichst gering sind. Trotzdem sollen auf das Objekt über eine Kontaktfläche Kräfte ausgeübt werden können, die aber von der Wechselwirkung zwischen Objekt und Tastsensor unabhängig sind. Dabei soll es möglich sein, Tastinformationen zu gewinnen, bevor das Objekt die Kontaktfläche berührt. Des weiteren soll eine Ankopplung zwischen Sensor und Objekt unabhängig von den geometrischen Gegebenheiten sicher gewährleistet sein. Der Tastsensor soll zudem geeignet sein, Informationen über die Oberflächenstruktur eines Objektes erhalten zu können.

Zur Lösung dieser Aufgabe schlägt die Erfindung vor, daß der Meßwandler die Krafteinwirkung auf die Faser mittels eines Kondensators in elektrische Signale umwandelt, wobei die Faser mit einem Ende an eine erste Elektrode des Kondensators mechanisch gekoppelt ist, welche relativ zu einer zweiten Elektrode beweglich ist.

Der besondere Vorteil der erfindungsgemäßen Vorrichtung besteht darin, daß der Tasteindruck über das freie Ende der Faser aufgenommen wird, wobei es durch die mechanische Ankopplung an den Meßwandler möglich wird, den Kondensator oder die Kondensatoren unterhalb einer Kontaktfläche oder um die Ränder einer Kontaktfläche herum anzuordnen. Dabei können die Fasern beispielsweise durch Löcher in der Kontaktfläche an die Oberfläche geführt werden oder alternativ die Ränder der Kontaktfläche seitlich überragen, um so eine Ankopplung zwischen Tastobjekt und Tastsensor herzustellen, ohne die Wechselwirkung zwischen der Kontaktfläche und dem Objekt zu beeinträchtigen.

Die mit der Erfindung erzielten Vorteile beruhen insbesondere darauf, daß die vom Sensor auf das Objekt ausgeübte Kraft nur von der Beschaffenheit der Fasern abhängt. Es lassen sich Naturfasern (z. B. Tierhaare) oder künstliche Fasern jeder Art abhängig von der Art der Anwendung verwenden. Bei Einsatz eines weichen Fasermaterials lassen sich unter Verwendung von geeigneten Meßwandlern Kontakt, Geschwindigkeit und/oder Vibration registrieren, wobei die von den Fasern auf das Objekt übertragene Kraft, mehr oder weniger unabhängig vom Abstand zwischen Meßwandler und Objekt, stets sehr gering ist und fast ausschließlich von den Fasereigenschaften abhängt. Die Sensoren deren Meßwandler über die Fasern mit dem Tastobjekt in Berührung gebracht werden, können auch zum reinen Abtasten von Objekten eingesetzt werden, ohne daß diese eine Kontaktfläche berühren. Auch wenn gegebenenfalls das Objekt mit einer Kontaktfläche in Berührung steht, können Berührungen dynamisch registriert werden, ohne daß durch den Sensor die Eigenschaften der Kontaktfläche maßgeblich beeinträchtigt werden.

Die vom Sensor erfaßte Fläche kann durch die Wahl der Dicke, Anzahl und Anordnung der Fasern vorgegeben werden, so daß gegebenenfalls auch eine Ertastung von feinen Oberflächen möglich ist.

Die erfindungsgemäße Vorrichtung, bei der als Meßwandler ein Kondensator mit einer beweglichen Elektrode mit der einer Faser mechanisch gekoppelt ist, verwendet wird, ist mit einfach Mitteln und kostengünstig realisierbar. Durch die mechanische Kopplung zwischen Faser und Kondensatorelektrode wird die Kapazität bei einer Krafteinwirkung auf die Faser geändert. Auf diese Weise wird eine Berührung des freien Endes der Tastfaser mit einem Objekt in ein elektrisches Signal umgewandelt. Vorteilhaft ist einerseits, daß sich bei dem erfindungsgemäßen Tastsensor die Empfindlichkeit leicht variieren und an die verwendeten Fasern anpassen läßt. Außerdem können die Abmessungen der Kondensatoren extrem klein sein, wodurch es möglich wird, eine Mehrzahl von erfindungsgemäßen Tastsensoren platzsparend beispielsweise an einem Greifarm eines Roboters anzubringen.

Durch die genannten Vorteile ergeben sich vielfältige Einsatzmöglichkeiten der vorliegenden Erfindung im Bereich der Robotik, Automation sowie in allen Gebieten, in denen die Aufnahme von dynamischen Tasteindrücken eine Rolle spielt.

Technische Umsetzungsmöglichkeiten bestehen darin, daß entweder die starren Elektroden des Kondensators relativ zueinander beweglich sind, wobei z. B. nach Patentanspruch **2** eine der beweglichen Elektroden federnd gelagert sein kann, oder daß gemäß Patentanspruch **3** die mit der Faser in Verbindung stehende Elektrode aus einem elastisch verformbaren Material besteht. Bei diesen Ausführungsformen läßt sich die Empfindlichkeit des Tastsensors leicht variieren und an die verwendeten Fasern anpassen.

Die von den Fasern ausgelösten Bewegungen der Kondensatorelektroden lassen sich auf einfache Weise auswerten, wobei es laut Patentanspruch **4** zur Registrierung von dynamischen Tastinformationen zweckmäßig ist, ein Mittel zur zeitaufgelösten Messung der Kapazität vorzusehen. Anhand dieser dynamischen Tastinformation läßt sich z. B. die Relativgeschwindigkeit zwischen dem Tastsensor und einem Objekt ermitteln.

Die Verwendung eines frequenzselektiven Filters gestattet es, auf einfache Weise vibrierende Tastsignale, wie sie z. B. von rutschenden oder gleitenden Objekten verursacht werden, zu detektieren.

Verwendet man nach Patentanspruch **6** zur Auswertung der Meßsignale geeignete Mittel zu elektronischen Datenerfassung und -auswertung, so ergibt sich im Zusammenhang mit den Patentansprüchen **7 - 9** insbesondere die Möglichkeit, die Tastinformationen von zwei oder mehr Meßwandlern derart miteinander zu verrechnen, daß eine ortsaufgelöste Berührungsdetektion ermögficht wird. Die je nach Bedarf flächig oder linienförmig angeordneten Elemente müssen hierzu auf geeignete Weise verschaltet sein. So ergibt sich die Möglichkeit, einerseits die Form und die Orientierung eines Objektes zu bestimmen und andererseits auch dessen Bewegungsrichtung ermitteln zu können.

Die Kombination des erfindungsgemäßen Tastsensors mit zusätzlichen Sensoren ohne Fasern ermöglicht es, eine taktile Sensorik aufzubauen, mit der statische und dynamische Tasteindrücke gleichzeitig registriert werden können. Der zusätzliche Kraftsensor kann dabei als Kontaktfläche ausgeführt sein, was z. B. für Anwendungen in der Robotik vorteilhaft ist. Bei einem mit dieser Kombination von Sensoren ausgestatteten Robotergreifer läßt sich eine für die Manipulation von Gegenständen optimale taktile Rückkopplung realisieren.

Vorteilhafte technische Realisierungsmöglichkeiten dieses Kombinationssensors ergeben sich aus den Patentansprüchen **11 - 13**. Gemäß Patentanspruch **11** werden die Fasersensoren unterhalb eines flächigen Kraftsensors angeordnet, wobei die Fasern dessen Detektionsebene durchstoßen. Auf diese Weise lassen sich statische und dynamische Tasteindrücke an jedem Punkt an der Kontaktfläche registrieren. Einfacher zu realisieren ist die Anordnung der Fasersensoren am Rand des flächigen Kraftsensors, bei der die Ortsauflösung der dynamischen Tastinformation entsprechend eingeschränkt ist. Nach Patentanspruch **13** eignet sich für den zusätzlichen Kraftsensor vorteilhafter Weise die Verwendung einer piezo-resitiven Folie.

Ausführungsbeispiele der vorliegenden Erfindung werden im folgenden anhand der Figuren 1- 8 diskutiert:
- Figur 1:: Prinzipskizze des erfindungsgemäßen Tastsensors
- Figur 2:: Schemazeichnung mit kapazitivem Meßwandler.
- Figur 3:: Anordnung von Fasersensoren unterhalb einer Kontaktfläche.
- Figur 4:: Anordnung von Sensoren mit Faserbündeln unterhalb einer Kontaktfläche.
- Figur 5:: Anordnung von Fasersensoren entlang der Ränder einer Kontaktfläche.
- Figur 6:: Zweidimensionale Anordnung einer Mehrzahl von Fasersensoren unterhalb einer Kontaktfläche.
- Figur 7:: Fasersensor unterhalb eines piezo-resitiven Kraftsensors.
- Figur 8:: Anordnung einer Mehrzahl von Fasersensoren unterhalb einer Anordnung von piezo-resitiven Kraftsensoren.

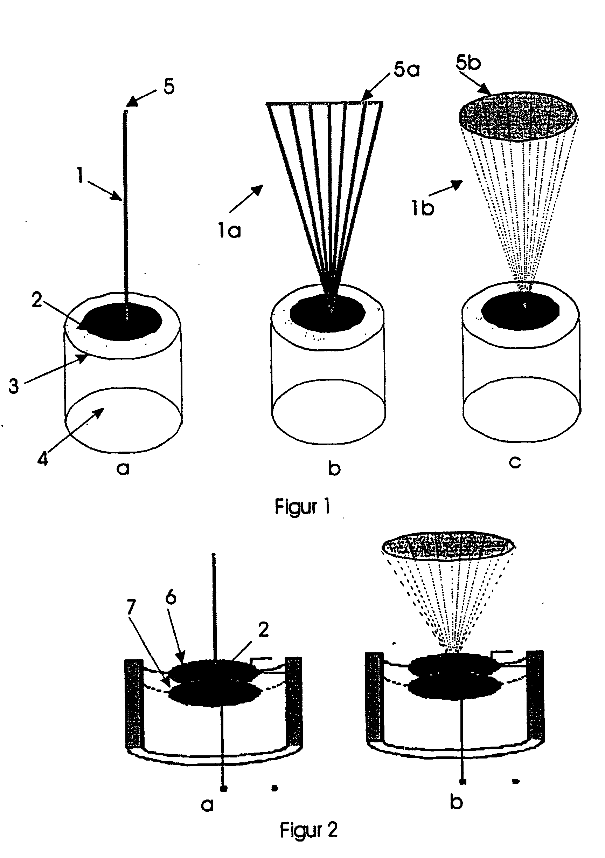

Figur 1 zeigt eine Prinzipskizze der verschiedenen möglichen Anordnungen von Tastfasern (1, 1A, 1B) auf einem kraftempfindlichen Meßwandler (4). Durch die unterschiedliche Anordnung der Fasern (1, 1A, 1B) kann die vom Sensor erfaßte Fläche (5, 5A, 5B) variiert werden. Der Sensor selbst muß dabei empfindlich genug sein, um die über die Fasern übertragenen Kräfte registrieren zu können. Die Verbindung (2) zwischen rezeptiven Element (3) und Tastfasern (1, 1A, 1B) kann durch geeignete Materialien (z. B. Silikonharz, Gummi) erfolgen.

Figur 2 zeigt einen Tastsensor, bei dem der Meßwandler aus einem Plattenkondensator besteht, dessen obere Platte (6) flexibel aufgehängt ist und den Abstand zur unteren Platte (7) ändern kann. Die Wahl eines Plattenkondensators als Meßwandler erlaubt es, sehr kleine Sensoren herstellen zu können, die außerdem in der Lage sind, auch schon sehr kleine auf die Kondensatorelektrode wirkende Kräfte zu registrieren und über die Fasern aufgenommene Vibrationen wahrzunehmen.

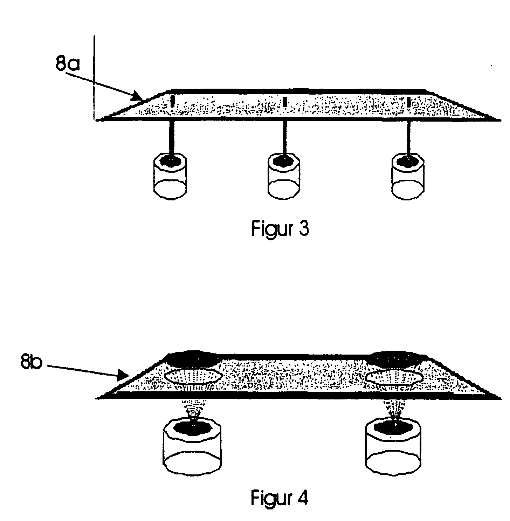

Figur 3 zeigt eine Anordnung von drei Tastsensoren unterhalb einer Kontaktfläche (8A). Die Bohrungen ändern die Eigenschaften der Kontaktfläche kaum und die Sensoren können in beliebiger Tiefe unterhalb der Kontaktfläche angeordnet werden. Es kann so z. B. zum Einsatz an Robotergreifern der Kontakt mit Objekten registriert werden. Durch Registrieren von Vibrationen kann einsetzendes Rutschen von auf der Fläche befindlichen oder die Fläche berührenden Objekten registriert werden. Durch Verändern der Faserlänge ist es möglich, schon vor der eigentlichen Berührung der Kontaktfläche (8A) in der Nähe befindliche Objekte zu registrieren und entsprechend zu reagieren, was z. B. zur Erkennung von Hindernissen im Bewegungsbereich eines Roboters genutzt werden kann.

Figur 4 zeigt eine weitere Anordnung von Tastfasern unterhalb einer Kontaktfläche (8B). Abhängig von der Anwendung kann es sinnvoll sein, die Größe und Form der von einem Sensor erfaßten Fläche zu verändern, was durch einfache Anpassung der Anordnung der Fasern möglich ist.

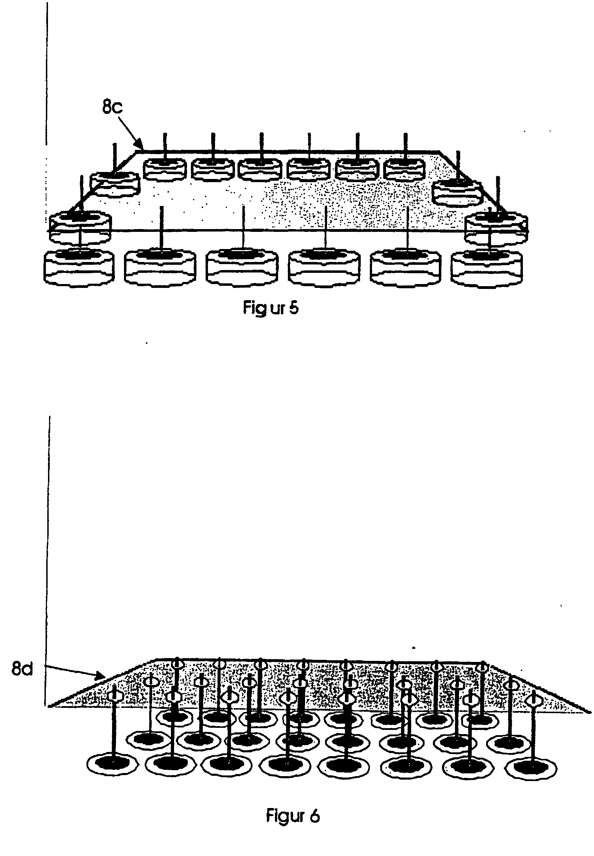

Figur 5 zeigt die Anordnung von Sensoren am Rand einer Kontaktfläche (8C). Auf diese Weise läßt sich durch Auswertung der Sensorsignale sehr einfach die Ausrichtung der Kontaktfläche relativ zu einem Objekt bestimmen. Dies kann zur Steuerung der Ausrichtung eines Robotergreifers genutzt werden.

Die Figur 6 zeigt die zweidimensionale Anordnung von Sensoren unterhalb einer Kontaktfläche (8D), wobei die Eigenschaften der Kontaktfläche durch die Bohrungen nur geringfügig verändert werden. Die Kontaktfläche ist dabei nicht notwendigerweise eben. Die Anordnung gestattet es, dynamische Tastinformationen von einem mit der Kontaktfläche in Berührung stehenden Objekt an jedem Punkt der Fläche zu ermitteln.

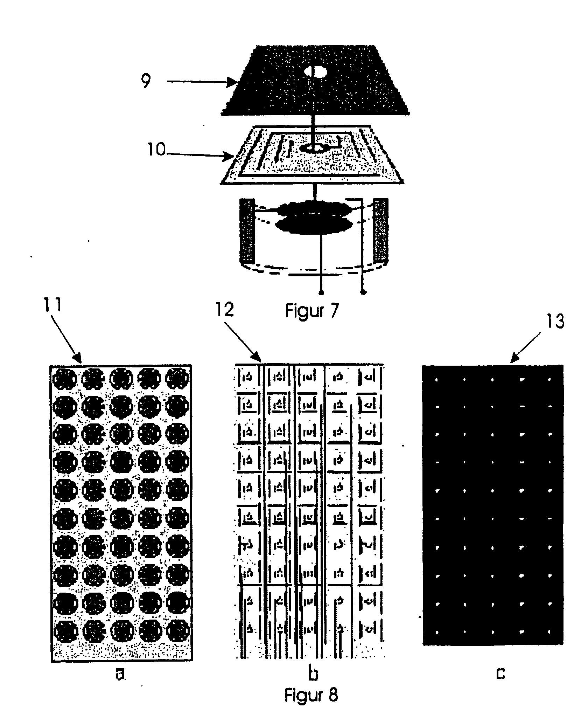

Figur 7 zeigt die Kombination eines erfindungsgemäßen Tastsensors mit einem zusätzlichen statischen Kraftsensor. Dieser aus zwei übereinanderliegenden Folien bestehende Sensor ändert seinen elektrischen Widerstand aufgrund des einwirkenden Druckes. Die untere Folie ist mit Elektroden versehen, über die der Widerstand der oberen Folie gemessen werden kann. Damit ist es möglich, die Krafteinwirkung auf die obere Folie ortsaufgelöst zu ermitteln. Mit der Kombination der beiden Sensortypen ist es möglich, gleichzeitig Informationen über statische Kräfte und über Geschwindigkeit und Vibration zu gewinnen.

Figur 8 zeigt den prinzipiellen Aufbau einer Anordnung von dynamischen Tastsensoren (11), welche unterhalb eines statischen Sensorfeldes (12, 13) angeordnet sind. Die Figur zeigt eine Draufsicht auf die Grundplatte (11) mit den darauf integrierten Fasersensoren. Die Fasern werden durch die Löcher in der Elektrodenschicht (12) und der Folienschicht (13) des statischen Sensorfeldes an die Oberfläche geführt.

## Patentansprüche

1. Vorrichtung zur Registrierung von Berührungen, mit wenigstens einem kraftempfindlichen Meßwandler (4), wobei die Kraftankopplung an den Meßwandler (4) über eine Faser (1) oder ein Faserbündel (1A, 1B) erfolgt, **dadurch gekennzeichnet, daß** der Meßwandler (4) die Krafteinwirkung auf die Faser (1) mittels eines Kondensators in elektrische Signale umwandelt, wobei die Faser mit einem Ende an eine erste Elektrode (6) des Kondensators mechanisch gekoppelt ist, welche relativ zu einer zweiten Elektrode (7) beweglich ist.

2. Vorrichtung nach Anspruch 1, **dadurch gekennzeichnet, daß** die bewegliche Elektrode (7) federnd gelagert ist.

3. Vorrichtung nach Anspruch 1, **dadurch gekennzeichnet, daß** die bewegliche Elektrode (7) aus einem elastisch verformbaren Material besteht.

4. Vorrichtung nach mindestens einem der Ansprüche 1 bis 3, **dadurch gekennzeichnet, daß** ein Mittel zur zeitaufgelösten Messung der Kapazität des Kondensators vorgesehen ist.

5. Vorrichtung nach Anspruch 4, **dadurch gekennzeichnet, daß** der Zeitverlauf der Kapazität mittels wenigstens eines frequenzselektiven Filters aufgenommen wird.

6. Vorrichtung nach mindestens einem der Ansprüche 1 bis 5, **dadurch gekennzeichnet, daß** der Meßwandler mit einem Mittel zur elektronischen Datenerfassung und Auswertung gekoppelt ist.

7. Vorrichtung nach Anspruch 6, **dadurch gekennzeichnet, daß** zur Auswertung der Tastinformation die Meßdaten von zwei oder mehr Meßwandler miteinander verrechnet werden.

8. Vorrichtung nach einem der Ansprüche 1 bis 7, **dadurch gekennzeichnet, daß** eine Mehrzahl von Meßwandlern, denen jeweils eine Faser (1) oder ein Faserbündel (1A, 1B) zugeordnet ist, zu einem flächen- oder linienförmigen Sensor angeordnet sind.

9. Vorrichtung nach Anspruch 8, **dadurch gekennzeichnet, daß** die Meßwandler derart verschaltet sind, daß eine ortsaufgelöste Berührungsdetektion ermöglicht wird.

10. Vorrichtung nach mindestens einem der vorhergehenden Ansprüche, **dadurch gekennzeichnet, daß** jeweils mit Fasern (1) oder Faserbündeln (1A, 1B) versehende Meßwandler mit wenigstens einem zusätzlichen Kraftsensor ohne Fasern kombiniert werden.

11. Vorrichtung nach Anspruch 10, **dadurch gekennzeichnet, daß** eine oder mehrere Fasern die Detektionsebene eines flächigen Kraftsensors durchstoßen.

12. Vorrichtung nach mindestens einem der Ansprüche 10 oder 11, **dadurch gekennzeichnet, daß** eine Mehrzahl von Meßwandlern mit Fasern oder Faserbündeln am Rand eines flächigen Kraftsensors angeordnet sind.

13. Vorrichtung nach mindestens einem der Ansprüche 10 bis 12, **dadurch gekennzeichnet, daß** der zusätzliche Kraftsensor über eine piezo-resistive Folie verfügt.

## Claims

1. Device for recording contacts, with at least one force-sensitive transducer (4), the force coupling to the transducer (4) taking place via a fibre (1) or a fibre bundle (1A, 1B), **characterized in that** the transducer (4) converts the action of the force on the fibre (1) into electrical signals using a capacitor, the fibres being mechanically coupled at one end to a first electrode (6) of the capacitor, which is movable relative to a second electrode (7).

2. Device according to claim 1, **characterized in that** the movable electrode (7) is elastically housed.

3. Device according to claim 1, **characterized in that** the movable electrode (7) consists of an elastically deformable material.

4. Device according to at least one of claims 1 to 3, **characterized in that** a means for time-resolved measurement of the capacitance of the capacitor is provided.

5. Device according to claim 4, **characterized In that** the variation in time of the capacitance is recorded using at least one frequency-selective filter.

6. Device according to at least one of claims 1 to 5, **characterized in that** the transducer is coupled with a means of electronic data acquisition and evaluation.

7. Device according to claim 6, **characterized In that** the measured data of two or more transducers are reconciled for the evaluation of the scanned information.

8. Device according to one of claims 1 to 7, **characterized in that** a plurality of transducers, to each of which a fibre (1) or a fibre bundle (1A, 1B) is allocated, are arranged on a flat or linear sensor.

9. Device according to claim 8, **characterized in that** the transducers are connected in such a way that a location-resolved contact detection is facilitated.

10. Device according to at least one of the previous claims, **characterized in that** transducers [to be] provided with fibres (1) or fibre bundles (1A, 1B) are each combined with at least one additional force sensor without fibres.

11. Device according to claim 10, **characterized in that** one or more fibres pierce the detection plane of a flat force sensor.

12. Device according to at least one of claims 10 or 11, **characterized in that** a plurality of transducers with fibres or fibre bundles are arranged on the edge of a flat force sensor.

13. Device according to at least one of claims 10 to 12, **characterized in that** the additional force sensor has a piezoresistive film.

## Revendications

1. Dispositif d'enregistrement de contacts, avec au moins un capteur de mesure (4) réagissant à la force, où le couplage de force au capteur de mesure (4) a lieu par une fibre (1) ou un faisceau de fibres (1A, 1B), **caractérisé en ce que** le capteur de mesure (4) transforme la force exercée sur la fibre (1) au moyen d'un condensateur en des signaux électriques, où la fibre est couplée mécaniquement avec une extrêmité à une première électrode (6) du condensateur, qui est déplaçable relativement à une deuxième électrode (7).

2. Dispositif selon la revendication 1, **caractérisé en ce que** l'électrode mobile (7) est logé dune manière élastique.

3. Dispositif selon la revendication 1, **caractérisé en ce que** l'électrode mobile (7) est constituée d'un matériau déformable élastiquement.

4. Dispositif selon au moins Tune des revendications 1 à 3, **caractérisé en ce qu'**un moyen est prévu pour la mesure définie dans le temps de la capacité du condensateur.

5. Dispositif selon la revendication 4, **caractérisé en ce que** l'allure dans le temps de la capacité est détectée par au moins un filtre à sélection de fréquence.

6. Dispositif selon au moins l'une des revendications 1 à 5, **caractérisé en ce que** le capteur de mesure est couplé avec un moyen pour la détection et évaluation électronique des données.

7. Dispositif selon la revendication 6, **caractérisé en ce que**, pour évaluer l'information de tâtage, les données de mesure de deux capteurs de mesure ou plus sont comptées.

8. Dispositif selon l'une des revendications 1 à 7, **caractérisé en ce qu'**une pluralité de capteurs de mesure, auxquels est associé respectivement une fibre (1) ou un paquet de fibres (1A, 1B), sont agencés en un capteur plan ou en forme de lignes.

9. Dispositif selon la revendication 8, **caractérisé en ce que** les capteurs de mesure sont commutés de façon à permettre une détection de contact définie localement.

10. Dispositif selon au moins l'une des revendications précédentes, **caractérisé en ce que** des capteurs de mesure pourvus respectivement de fibres (1) ou de paquets de fibres (1A, 1B) sont combinés avec au moins un capteur de force additionnel sans fibres.

11. Dispositif selon la revendication 10, **caractérisé en ce qu'**une ou plusieurs fibres transpercent le plan de détection d'un capteur de force plan.

12. Dispositif selon au moins l'une des revendications 10 ou 11, **caractérisé en ce que** plusieurs capteurs de mesure avec des fibres ou des paquets de fibres sont disposés au bord d'un capteur de force plan.

13. Dispositif selon au moins l'une des revendications 10 à 12, **caractérisé en ce que** le capteur de force additionnel dispose dune feuille piézorésistive.
